**Europäisches Patentamt**

**European Patent Office**

**Office européen des brevets**

(19)

(11) Numéro de publication : **0 572 311 A1**

# (12) DEMANDE DE BREVET EUROPEEN

(21) Numéro de dépôt : **93401333.5**

(22) Date de dépôt : **25.05.93**

(51) Int. Cl.⁵ : **G01R 1/20**

(30) Priorité : **27.05.92 FR 9206498**

(43) Date de publication de la demande :
**01.12.93 Bulletin 93/48**

(84) Etats contractants désignés :
**DE GB IT**

(71) Demandeur : **SEXTANT Avionique**
**5/7 rue Jeanne Braconnier Parc Tertiaire**
**F-92368 Meudon la Forêt Cédex (FR)**

(72) Inventeur : **Marchand, André**
**30 Avenue Pierre-Benoît**
**F-26500 Bourg les Valence (FR)**
Inventeur : **Jacquier, Gilberte**
**46 Avenue Marcellin Berthelot**
**F-38100 Grenoble (FR)**

(74) Mandataire : **Bloch, Gérard et al**
**2, square de l'Avenue du Bois**
**F-75116 Paris (FR)**

(54) **Capteur de courant résistif.**

(57) L'invention concerne les capteurs de courant comportant un élément résistif (2) monté sur un support (10), des moyens d'alimentation en courant et des moyens de mesure de la tension créée par le courant dans l'élément résistif (2).

Avantageusement, les capteurs de courant selon l'invention (50, 60, 70, 80) comprennent des moyens conducteurs (20, 30, 71, 75, 81, 82) reliés à une région de l'élément résistif (2) qui n'est pas perturbée par des soudures (3, 3a, 3b). Les moyens conducteurs de l'invention peuvent être utilisés pour l'alimentation en courant ou la mesure de tension.

L'invention s'applique notamment à la fabrication de capteurs de courant dans des circuits hybrides ou les circuits imprimés.

Fig. 3A

EP 0 572 311 A1

La présente invention concerne les capteurs de courant comprenant un élément résistif monté sur un support, des moyens pour alimenter en courant l'élément résistif, et des moyens pour mesurer la tension créée par le courant dans l'élément résistif.

La présente invention concerne plus particulièrement les capteurs de courant fabriqués selon la technologie des circuits imprimés, ou celle des circuits hybrides à substrat céramique.

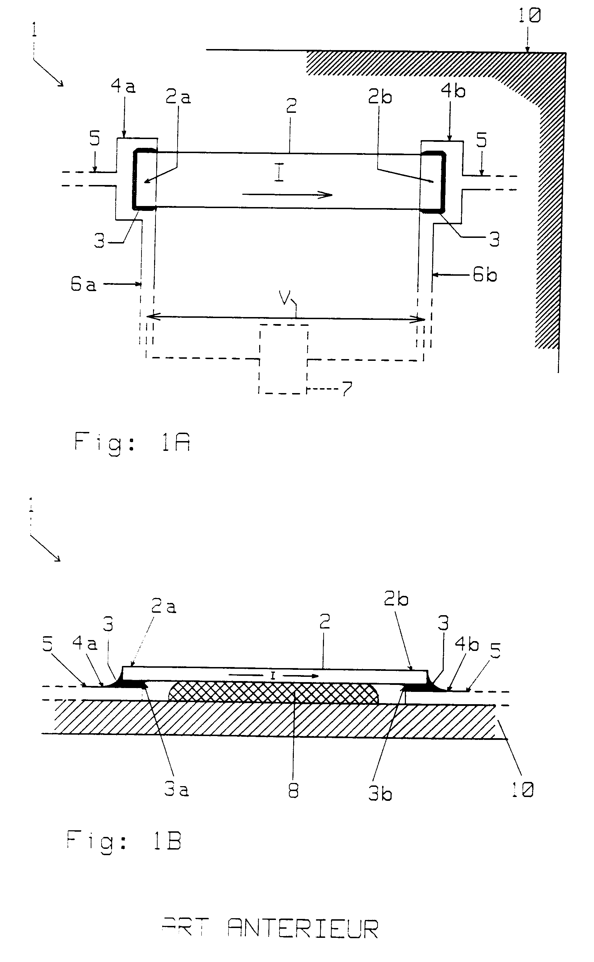

De façon classique, comme l'illustre la vue de dessus de la figure 1A et la vue en coupe de la figure 1B, un capteur de courant résistif 1 comprend un élément résistif 2 ayant deux extrêmités 2a, 2b fixées au moyen d'une soudure 3 sur des plages conductrices 4a, 4b d'un circuit 10. L'élément résistif 2 est disposé en série avec une piste conductrice 5 aboutissant à la plage 4a et se prolongeant après la plage 4b. La piste conductrice 5 est parcourue par un courant I à mesurer (ou à surveiller). Le courant I traversant l'élément résistif 2 crée une tension V détectée au moyen de deux pistes conductrices ou bras de mesure 6a, 6b, issus des plages 4a, respectivement 4b, et menant à un dispositif de mesure (ou de détection) quelconque 7.

On appellera par la suite "résistance de conversion" R la valeur de la résistance électrique entre les deux bras de mesure 6a, 6b, déterminant la conversion du courant I en tension V mesurée.

L'élément resistif 2 est généralement constitué d'un alliage metallique présentant une résistivité sensiblement indépendante de la température, afin que la résistance de conversion R soit invariable dans la plage de temperature dans laquelle fonctionne le capteur courant 1.

De tels alliages - par exemple les alliages nickel-cuivre ou nickel-cuivre-manganèse - sont disponibles auprès de divers fabricants et sont proposés sous divers conditionnements, par exemple en rubans, en barres, en fils, ... L'élément résistif 2 tel qu'il est représenté sur les figures 1A, 1B, est obtenu à partir d'un ruban d'un tel alliage.

Communément, la résistance électrique de l'élément résistif 2 est très faible, de l'ordre de quelques milliohms, principalement afin d'éviter une dissipation thermique excessive qui endommagerait la soudure 3.

Pour améliorer la conduction thermique entre l'élément résistif 2 et le circuit 10, il est par ailleurs habituel de disposer une colle thermiquement conductrice 8 entre l'élément résistif 2 et le circuit 10, comme représenté sur la figure 1B.

Les capteurs de courant du type décrit ci-dessus présentent de grands avantages en raison de leur simplicité de fabrication.

Il est néamnoins difficile d'obtenir une valeur précise de la résistance de conversion R lors d'une fabrication en série. On a représenté sur la figure 1B des débordements 3a, 3b de la soudure 3 qui se produisent sous l'élément résistif 2, lors de la fusion de la soudure 3. Ce phénomène, connu de l'homme de métier, a pour effet de court-circuiter partiellement l'élément résistif 2 dans sa partie utile, située entre les plages 4a et 4b, diminuant ainsi de façon aléatoire la valeur de la résistance de conversion R entre les bras de mesure 6a, 6b. En pratique, on constate que la valeur de la résistance de conversion varie dans une fourchette de 8 %

En outre, les variations en température de la résistance de conversion R sont beaucoup plus importantes que ce que laisse prévoir l'utilisation d'un alliage dont la résistivité est peu sensible à la température. Ce fait est attribuable à l'influence de la résistivité de la soudure 3 et celle du matériau conducteur constituant les plages 4a, 4b. Ce phenomène est très marqué sur les circuits hybrides, dans lesquels les matériaux employés pour les couches conductrices (Au ; Pt Au ; Pd Ag ; W) présentent une résistivité du même ordre de grandeur que celle de l'alliage constituant l'élément résistif 2, et très sensible aux écarts de températures.

On a par ailleurs propose dans le document FR-A-2 568 684, un dispositif capteur de courant, comprenant un élément résistif monté sur un support, des moyens pour alimenter en courant l'élément résistif, et des moyens pour mesurer la tension créée par le courant dans l'élément résistif, moins un desdits moyens comprenant des moyens conducteurs reliés à une région de l'élément résistif non perturbée par des soudures de connection de l'élément résistif.

Toutefois, dans ce document, les moyens conducteurs sont réalisés d'une seule pièce avec l'élément résistif, de sorte que la valeur de résistance de ce dernier ne peut être ajustée. On utilise donc une résistance additionnelle ayant elle-mème sa valeur ajustée par laser. Le dispositif connu est donc coûteux et complexe à réaliser.

Un objet de la présente invention est de pallier ces inconvénients, et de permettre l'obtention d'un capteur de courant de précision peu sensible aux variations de température et de réalisation relativement simple.

Un autre objet de la présente invention est de permettre la fabrication en série de capteurs de courant sans dispersion des valeurs de la résistance de conversion.

A cet effet, l'invention prévoit tout d'abord un dispositif du type rappelé ci-dessus, dans lequel lesdits moyens sont rapportés, notamment par soudure, sur l'élément résistif.

Ainsi, la stabilité en température du capteur de courant selon l'invention ne dépend que de la stabilité du matériau constituant l'élément résistif.

De surcroît, on verra ci-après que l'ajustement de la valeur de résistance de l'élément résistif est grandement facilité.

Avantageusement, ledit support comprend des plages conductrices auxquelles sont reliées respectivement les extrêmités distales desdits moyens conducteurs.

Selon un mode de réalisation, lesdits moyens conducteurs sont des fils soudés ultrasoniquement sur l'élément résistif.

Les fils peuvent ainsi relier directement le capteur de courant selon l'invention à un dispositif de mesure ou de détection de tension, ou des plages conductrices du support.

Selon un autre mode de réalisation, lesdits moyens conducteurs sont des conducteurs rigides soudés électriquement sur l'élément résistif.

On peut ainsi fabriquer le capteur de courant selon l'invention avant de le monter sur le support.

Selon une variante de réalisation, le capteur de courant selon l'invention est caractérisé en ce que l'élément résistif est collé sur ledit support, et en ce que les moyens pour alimenter en tension et les moyens pour mesurer la tension comprennent chacun des fils soudés sur l'élément résistif.

On choisira de préférence un alliage de métaux choisis parmi le groupe constitue par le cuivre, le nickel et le manganèse, pour la réalisation dudit élément résistif.

De préférence, ledit support est choisi parmi le groupe constitué par les circuits imprimés et les circuits hybrides.

L'invention prévoit également un procédé de fabrication du dispositif ci-dessus, dans lequel on rapporte, notamment par soudage, lesdits moyens conducteurs sur l'élément résistif en un point choisi pour donner audit élément une valeur de résistance prédéterminée.

La position dans laquelle on rapporte les moyens conducteurs peut notamment être ajustée en mesurant simultanément la résistance de l'élément résistif.

Ces objets, caractéristiques et avantages ainsi que d'autre de la présente invention seront exposés plus en détail dans la description suivante d'exemples de réalisations particuliers faite en relation avec les figures jointes parmi lesquelles :

- les figures 1A et 1B destinées à illustrer l'état de la technique ont été décrites précédemment,
- la figure 2A represente une vue de dessus d'un premier exemple de réalisation d'un capteur de courant selon la présente invention,
- la figure 2B illustre un procédé de réalisation d'un capteur de courant selon la présente invention,
- la figure 3 représente une vue de dessus d'un deuxième exemple de réalisation d'un capteur de courant selon la présente invention,
- la figure 4 représente une vue de dessus d'un troisième exemple de réalisation d'un capteur de courant selon la présente invention.

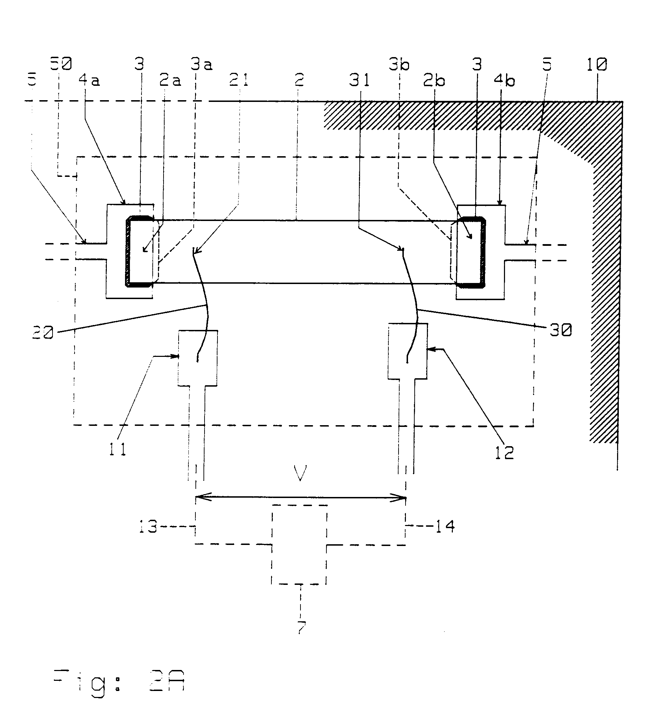

La figure 2A représente un capteur de courant 50 selon la présente invention. Le capteur de courant 50 comprend, comme celui des figures 1A et 1B, un élément résistif 2 soudé par ses extrémités 2a, 2b à des plages 4a, 4b d'un circuit 10, au moyen d'une soudure 3, l'ensemble étant disposé en série avec une ligne conductrice 5 du circuit 10.

On a représenté en pointillé les débordements 3a et 3b de la soudure 3 décrits dans le préambule, situés sur la face inférieure de l'élément résistif 2, a proximité des plages 4a, 4b.

Le capteur de courant 50 de l'invention comprend en outre deux fils électriques de mesure, respectivement 20, 30, soudés sur a face supèrieure de l'élément résistif 2, les extrémités distales des fils 20, 30 étant respectivement soudés sur des plages de cablage 11,12 se prolongeant par des pistes conductrices 13,14 menant à un dispositif 7 de mesure ou de détection de tension.

Selon l'invention, les points de contact 21, 31 des fils 20,30 avec l'élément résistif 2 sont disposés au-delà des zones de l'élément résistif 2 court-circuitées par la soudure 3 ou par les débordements 3a, 3b de la soudure 3.

Ainsi, les fils de mesure 20,30 remplacent avantageusement les bras de mesure des dispositifs de l'art antérieur, car la résistance de conversion R du capteur 50 de l'invention, située ici entre les points de soudure 21, 31 des fils de mesure 20, 30, ne dépend que de la résistivité du matériau constituant l'élément résistif 2.

Par ailleurs, la stabilité en température du capteur de courant 50 ne dépend que de la stabilité du matériau constituant l'élément résistif 2, et on choisira de préférence des alliages résistifs du type nickel-cuivre ou nickel-cuivre-manganèse.

L'exemple de réalisation de l'invention décrit ci-dessus se prête bien aux techniques de montage utilisées pour les circuits imprimés, et ainsi qu'à celles utilisées pour les circuits hybrides. Le tableau ci-dessous donne un aperçu non limitatif et non exhaustif des technologies utilisables pour la réalisation d'un capteur de courant selon l'invention.

EP 0 572 311 A1

| Circuit | Conducteur constituant les plages conductrices (4a, 4b, 11, 12) | Soudure (3) de l'élément résistif (2) | Fils électriques (20, 30) | Soudure des fils électriques (20, 30) |
|---|---|---|---|---|
| Circuits hybrides fabriqués selon la technologie dite "couche épaisse" et Circuits hybrides fabriqués selon la technologie dite "des coffrités basse température" | Or(Au) | Soudure à l'or-étain (Sn-Au) | Fils d'aluminium | Soudure ultra-sonique |
| | | | Fils d'or | Soudure ultrasonique ou thermosonique |
| | Ag, PdAg, PtAu, Cu (conducteurs étamables) | Soudure étain-Plomb (Sn-Pb) | Fils de cuivre monobrins | Soudure à l'étain plomb (SnPb) / Soudure électrique par point |
| | | | Fils de cuivre multibrins | Soudure à l'étain-plomb (Sn-Pb) |
| Circuits hybrides fabriqués selon la technologie dite des "coffrités haute température" | Tungstène, recouvert d'une couche de nickel et d'or (W+Ni+Au) | Soudure à l'or-étain (Sn-Au) | Fils d'aluminium | Soudure ultrasonique |
| | | | Fils d'or | Soudure ultrasonique ou thermosonique |
| Circuits imprimés | Cuivre (Cu) | Soudure étain-plomb (Sn-Pb) | Fils de cuivre monobrins | Soudure électrique par point / Soudure étain-plomb (Sn-Pb) |
| | | | Fils de cuivre multibrins | Soudure étain-plomb (Sn-Pb) |

On décrira maintenant un procédé de cablage des fils de mesure 20, 30 permettant d'ajouter la résistance de conversion R du capteur 50 avec une grande précision. Pour des raisons de simplicité, on se limitera aux procédés de fabrication utilisant la soudure ultrasonique (cf tableau).

En référence à la figure 2 B, on injecte un courant prédéterminé Ip dans l'élément résistif 2, par exemple au moyen de pointes de test 40, 41 disposées sur la piste conductrice 5 et reliées à un générateur de courant 45. On dispose d'autres pointes de test 42, 43 sur les plages de mesure 11, 12, les pointes 42, 43 étant reliées à un voltmètre 44.

On soude tout d'abord un premier fil 20 entre une plage de mesure 11 et l'élément résistif 2, au moyen d'une machine de cablage aux ultrasons 46.

On soude ensuite le deuxième fil 30 sur la plage de mesure 12 restante, et on recherche, avant de souder l'extrêmité 31 du fil 30 sur l'élément résistif 2, l'emplacement donnant, en lecture du voltmètre 44, la tension Vp correspondant à la résistance de conversion R souhaitée (Vp = R Ip).

Pour cela, on pose l'extrêmité 47 de la machine de cablage 46 sur l'élément résistif 2 pour établir un contact entre l'extrémité 31 du fil 30 et l'élément résistif 2, et on repète cette opération jusqu'à ce que le bon emplacement pour la soudure du fil 30 soit trouvé. Sur la figure 2B, une flèche indique l'axe selon lequel s'effectue la recherche de l'emplacement de soudure.

On obtient ainsi un calibrage très précis du capteur de courant selon l'invention.

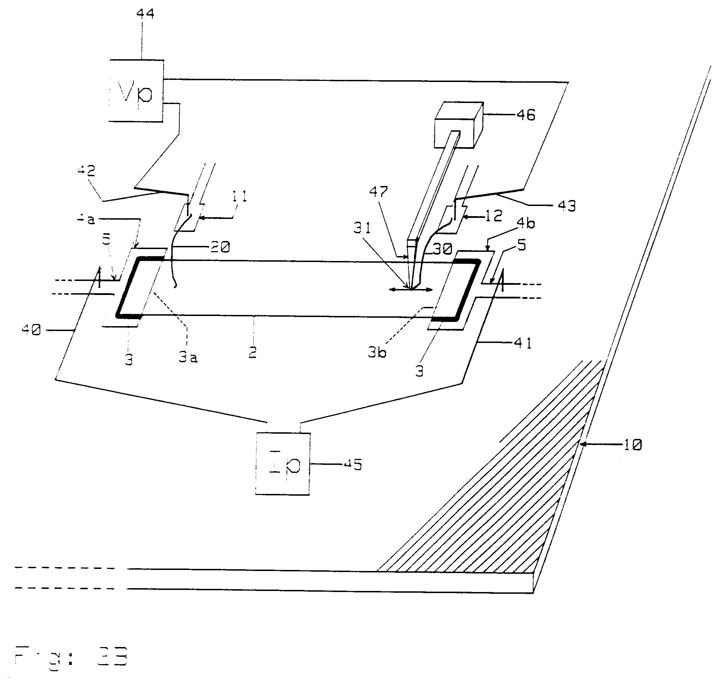

La figure 3 représente un autre exemple de réalisation d'un capteur de courant 60 selon l'invention, dans lequel on peut aussi utiliser le procédé décrit ci-dessus.

Dans cet exemple, l'élément résistif 2 est collé sur le circuit 10 au moyen d'une colle isolante 15 ayant de préférence une bonne conductivité thermique.

Les fils de mesure 20, 30 et les plages de mesure 11, 12 décrits précédemment sont conservés. On remplace ici les plages conductrices d'alimentation en courant décrites plus haut par des fils 65, 67 soudés aux extrémités 2a, 2b de l'élément résistif 2, et reliant l'élément résistif à la piste conductrice 5 par l'intermédiaire de plages de cablage 66, 68 sur lesquelles sont soudées les extrémités distales des fils 65, 67.

Il apparaîtra clairement à l'homme de l'art que de nombreuses variantes de la présente invention peuvent être réalisées en combinant les exemples de la figures 2A et l'exemple de la figure 3.

Il apparaîtra aussi à l'homme de l'art que dans certaines conditions d'utilisation, les moyens d'alimentation et les moyens de mesure peuvent être intervertis. Ainsi, dans la figure 2A, les fils de mesure 20, 30 pourraient être utilisés pour l'alimentation en courant, et les plages 4a, 4b comme moyens de mesure ; la mesure d'une tension s'effectuant avec un courant pratiquement nul, la mesure ne serait pas entachée des erreurs dues aux variations de résistivité de la soudure 3 et du matériau constituant les plages conductrices 4a, 4b.

Il en est de même pour l'exemple de la figure 3, où les fils d'alimentation 65, 67 pourraient être utilisés pour la mesure, et les fils de mesure 20, 30 pour l'alimentation en courant. Dans une autre variante de réalisation, on pourrait aussi multplier le nombre de fils d'alimentation 65,67 afin de permettre le passage d'un courant plus important.

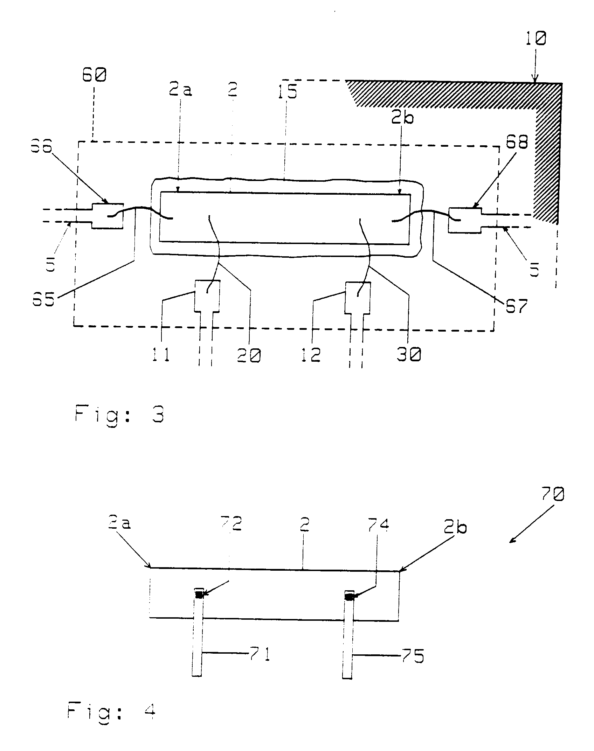

On a représenté sur la figure 4 une variante de réalisation de capteurs de courant selon l'invention, pouvant être fabriqués avant d'être montés sur un circuit.

Le capteur de courant 70 de la figure 4 comprend deux conducteurs rigides 71, 75, par exemple en cuivre, disposés perpendiculairement à l'élément résistif 2 et soudés chacun en un point 72,74 de l'élément résistif 2, par soudure électrique. L'ensemble formé par l'élément résistif 2 et les deux conducteurs 71, 75 forme un composant prêt à être monté ou soudé sur les plages d'un circuit, par les extrémités 2a et 2b de l'élément résistif 2 et les extrémités distales des conducteurs 71 et 75.

Le capteur de courant de la figure 4 convient particulièrement bien à une fabrication en série tout en permettant d'obtenir une grande précision pour ce qui est de la résistance de conversion.

On notera que la présente invention n'est pas limitée aux exemples de réalisaticn décrits.

L'homme de l'art pourra apporter diverses variantes et modifications à la présente invention, notamment en ce qui concerne les choix des matériaux et la forme de l'élément résistif.

**Revendications**

1. Dispositif capteur de courant (50,60,70,80), comprenant un élément résistif (2) monté sur un support (10), des moyens pour alimenter en courant l'élément résistif, et des moyens pour mesurer la tension créée par le courant dans l'élément résistif, au moins un desdits moyens comprenant des moyens conducteurs (20,30,71,75,81,82) reliés à une région de l'élément résistif (2) non perturbée par des soudures (3,3a,3b) de connexion de l'élément résistif, caractérisé par le fait que lesdits moyens conducteurs sont rapportés sur l'élément résistif.

2.  Dispositif selon la revendication 1, dans lequel lesdits moyens conducteurs sont soudés sur l'élément résistif.

3.  Dispositif capteur de courant (50,60,70,80), selon l'une des revendications 1 et 2, caractérisé en ce que ledit support (10) comprend des plages conductrices (11,12) auxquelles sont reliées respectivement les extrémités distales desdits moyens conducteurs (20,30,71,75,81,82).

4.  Dispositif capteur de courant (50,60) selon l'une des revendications 1 à 3, dans lequel lesdits moyens conducteurs sont des fils (20,30) soudés ultrasoniquement sur l'élément résistif (2).

5.  Dispositif capteur de courant (70) selon l'une des revendications 1 à 3, dans lequel lesdits moyens conducteurs sont des conducteurs rigides (71,75) soudés électriquement sur l'élément résistif (2).

6.  Dispositif capteur de courant (60) selon la revendication 4, caractérisé en ce que l'élément résistif (2) est collé (15) sur ledit support (10), et en ce que les moyens pour alimenter en tension et les moyens pour mesurer la tension comprennent chacun des fils (20,30,65,67) soudés sur l'élément résistif (2).

7.  Dispositif selon l'une des revendications 1 à 6, dans lequel ledit support est choisi parmi le groupe constitué par les circuits imprimés et les circuits hybrides.

8.  Dispositif selon l'une des revendications 1 à 7, dans lequel ledit élément résistif est constitué d'un alliage de métaux choisis parmi le groupe constitué par le cuivre, le nickel et le manganèse.

9.  Procédé ou fabrication d'un dispositif selon l'une quelconque des revendications 1 à 8, caractérisé par le fait que l'on rapporte lesdits moyens conducteurs sur l'élément résistif en un point choisi pour donner audit élément une valeur de résistance prédéterminée.

10. Procédé selon la revendication 9, dans lequel on ajuste la position dans laquelle on rapporte les moyens conducteurs en mesurant simultanément la résistance de l'élément résistif.

Fig: 1A

Fig: 1B

ART ANTERIEUR

Fig: 2A

Fig: 23

Fig: 3

Fig: 4

**EP 0 572 311 A1**

Office européen
des brevets

**RAPPORT DE RECHERCHE EUROPEENNE**

Numero de la demande

EP    93 40 1333

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | FR-A-2 568 684 (TELEMECANIQUE)<br><br>* page 5, alinéa 4 *<br>--- | 1,2,5,7,9,10 | G01R1/20 |
| A | ELEKTRONIK<br>vol. 37, no. 9, Avril 1988, MUENCHEN,DE<br>pages 126 - 132<br>JACQUES 'Platin-und Iridium-Dunnschichtmesswiderstaende'<br>* page 130, colonne 2, alinéa 6; figure 8 *<br><br>----- | 3,4 | |

| | DOMAINES TECHNIQUES RECHERCHES (Int. Cl.5) |
|---|---|
| | G01R |

Le présent rapport a été établi pour toutes les revendications

| Lieu de la recherche | Date d'achèvement de la recherche | Examinateur |
|---|---|---|
| LA HAYE | 26 JUILLET 1993 | HOORNAERT W. |